# EUROPEAN PATENT APPLICATION

(11) **EP 4 726 766 A1**
(43) Date of publication of application: **15.04.2026**
(21) Application number: 24205822.0
(22) Date of filing: 10.10.2024
(51) Int. Cl.: H01J 37/02, H01J 37/153, H01J 37/22, H01J 37/244, H01J 37/28

(54) **CHARGED PARTICLE-OPTICAL APPARATUS**

(71) Applicant: ASML Netherlands B.V., 5500 AH Veldhoven (NL)
(72) Inventor: SAHIN, Ezgi, 5500 AH Veldhoven (NL); DE LEON ARIZPE, Israel, 5500 AH Veldhoven (NL); VAN T WESTEINDE, Maaike, 5500 AH Veldhoven (NL); LÖW, Peter, 5500 AH Veldhoven (NL); MANGNUS, Albertus, Victor, Gerardus, 5500 AH Veldhoven (NL); WIELAND, Marco, Jan-Jaco, 5500 AH Veldhoven (NL)
(74) Representative: ASML Netherlands B.V.

(57) **Abstract**

An electron-optical projection device for projecting at least one charged particle beam towards a sample, the device comprising: a beam directing element configured to project the at least one charged particle beam towards a sample location on the sample, wherein the electron-optical projection device further comprises an optical member configured to direct stimulation light towards the sample so that the stimulation light is at least partially coincident with the at least one charged particle beam, wherein the optical member comprises a first surface facing down-beam, at least part of the first surface comprising a coating layer being at least partially transparent for the stimulation light and being electrically conductive.

## Description

### FIELD

The present invention relates to an electron-optical projection device for projecting at least one charged particle beam towards a sample.

### BACKGROUND

During manufacturing processes of, for example, semiconductor integrated circuit (IC) chips or displays, undesired defects may occur on a substrate (e.g. wafer) or a mask. Such defects may reduce yield. Defects may occur as a consequence of all kinds of processing necessary to produce an integrated circuit or display, for example, lithography, etching, deposition or chemical mechanical polishing. Defects may include patterning defects, in which the created pattern lies outside the pattern tolerance for the process, and particles. Monitoring the extent of defects during the manufacturing processes is therefore important. Such monitoring (or more generally assessment) includes the determination of the existence of a defect, but also the classification of the types of defects found.

For the assessment of a sample, different types of inspection or metrology systems have been used, including charged particle systems such as electron microscopes. Such assessment for inspection may relates to defects, for example the existence and classification of such defects. Electron microscopes typically generate a probe beam (also often referred to as primary beam) which may, for example, be scanned across a part of the substrate (such as in a scanning electron microscopes (SEM)). Collecting interaction products that result from the interaction of the primary beam with the part of the substrate, allows the electron microscope to collect data representing the probed part of the substrate. The data may be processed/rendered for example by the electron microscope to generate an image representation of the part of the substrate. The collected data for example as a generated image representation allows for measuring structures on the part of the substrate, or allows for identifying defective structures by comparing the image representation with a reference. Such measurement may be referred to as metrology; the identification of defective structures may be referred to as (defect) inspection. The interaction products may contain charged particles which may be referred to as signal particles (e.g. signal electrons), such as secondary electrons and backscattered electrons, and may contain other interaction products, such as X-ray radiation.

When the primary electron beam scans the sample, charges may be accumulated on the sample due to the beam current, which may affect the quality of the image. The material structure may be illuminated with light and/or flooded with electrons in order to improve the defect contrast during defect inspection. For example, to regulate the accumulated charges on the sample, an Advanced Charge Controller (ACC) module may be employed to illuminate a light beam, such as a laser beam, on the sample, so as to control the accumulated charges due to effects such as photoconductivity, photoelectric, or thermal effects. The term ACC is used in the description below as shorthand for illumination by a light beam. It is to be understood that the term ACC refers generally to illumination by a light beam. It can be difficult to illuminate the light beam on the sample. For example, the dimensions of the pattern inspection tool may make it difficult to reach the sample with the light beam.

The ACC module may comprise a photonics layer which guides the light along its length. The photonics layers are generally made from insulating materials. This may be problematic because dielectric structures can charge up by the interaction with signal particles (e.g. secondary and backscattered electrons) created by the sample. The presence of built up charge near the primary charged particle beam may reduce the stability of the beam. It is desirable to provide an ACC module which can effectively illuminate the sample surface by a light beam, without affecting the stability of the primary beam.

### SUMMARY

According to an aspect of the present invention, there is provided an electron-optical projection device for projecting at least one charged particle beam towards a sample, the device comprising: a beam directing element configured to project the at least one charged particle beam towards a sample location on the sample, wherein the electron-optical projection device further comprises an optical member configured to direct stimulation light towards the sample so that the stimulation light is at least partially coincident with the at least one charged particle beam, wherein the optical member comprises a first surface facing down-beam, at least part of the first surface comprising a coating layer being at least partially transparent for the stimulation light and being electrically conductive.

### BRIEF DESCRIPTION OF THE DRAWINGS

Embodiments of the invention will now be described, by way of example only, with reference to the accompanying schematic drawings, in which:
- Figure 1 is a schematic diagram of an exemplary assessment apparatus;
- Figure 2 schematically depicts a multi-beam charged particle-optical device, for example of the assessment apparatus of Figure 1;
- Figure 3 schematically depicts a multi-beam charged particle-optical device, for example of the assessment apparatus of Figure 1;
- Figure 4 schematically depicts an alternative multi-beam charged particle-optical device, for example of the assessment apparatus of Figure 1;
- Figure 5 schematically depicts a charged particle-optical device array;
- Figure 6 schematically depicts an alternative multi-beam charged particle-optical device, for example of the assessment apparatus of Figure 1;
- Figure 7 schematically depicts a detector array in plan view;
- Figure 8 schematically depicts a detector element in cross-section;
- Figure 9 schematically depicts (part of) an electron-optical projection device in cross-section;
- Figure 10 schematically depicts an alternative embodiment of (part of) an electron-optical projection device in cross-section;
- Figure 11 schematically depicts a further alternative embodiment of (part of) an electron-optical projection device in cross-section;
- Figure 12 schematically depicts another alternative embodiment of (part of) an electron-optical projection device in cross-section;
- Figure 13 schematically depicts another alternative embodiment of (part of) an electron-optical projection device in cross-section;
- Figure 14 shows the effect of outcoupling power of different materials;
- Figure 15 schematically depicts an electron-optical projection device surface having optical members disposed thereon in plan view;
- Figure 16 schematically depicts an electron-optical projection device surface having optical members disposed thereon in cross-section;
- Figure 17 schematically depicts an alternative embodiment of (part of) an electron-optical projection device surface having optical members disposed thereon in cross-section;
- Figure 18 schematically depicts a further embodiment of (part of) an electron-optical projection device surface having optical members disposed thereon in cross-section;
- Figure 19 schematically depicts another alternative embodiment of (part of) an electron-optical projection device surface having optical members disposed thereon in cross-section;

The Figures are schematic. Within the following description of drawings, the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred to with reference to electrons, throughout the present document may therefore be more generally be considered to be references to charged particles, and items referred to in reference to charged particles, with the charged particles not necessarily being electrons. For example, references to an electron-optical device may more generally be considered to be references to a charged particle-optical device

### DETAILED DESCRIPTION

There is a trend in the semiconductor industry (often known as "Moore's law") to reduce the physical dimensions of structures representing circuit components on a substrate and/or to increase the packing density of such structures, in order to reduce the physical size of electronic devices and/or enhance the computing power of electronic devices. The physical dimensions of such structures may be reduced and/or the packing density of such structures may be increased by increasing lithographic resolution. Manufacturing processes of semiconductor IC chips can have 100s of individual steps. An error in any step of the manufacturing process has the potential to adversely affect the functioning of the electronic device. It is desirable to improve the overall yield of the manufacturing process. For example, to obtain a 75% yield for a 50-step manufacturing process (where a step may indicate the number of layers formed on a substrate), each individual step must have a yield greater than 99.4%. If an individual step has a yield of 95%, the overall yield of the manufacturing process would be as low as 7-8%. It is desirable to determine defects quickly so as to maintain a high substrate throughput, defined as the number of substrates processed per hour.

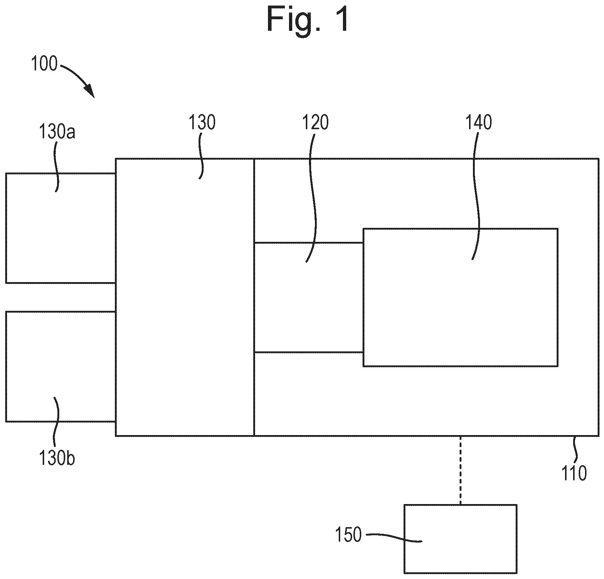

Figure 1 is a schematic diagram illustrating an exemplary assessment apparatus 100, e.g. a metrology apparatus or an inspection apparatus. The assessment apparatus 100 may be configured to scan a sample with one or more beams of electrons. The sample may be a semiconductor substrate, a substrate made of other material, or a mask, for example. The electrons interact with the sample and generate interaction products. The interaction products comprise signal electrons, e.g. secondary electrons and/or backscattered electrons, and possibly X-ray radiation. The assessment apparatus 100 may be configured to detect the interaction products from the sample so that a data set may be generated which may be processable into an image or any other data representation of the scanned area of the sample. For clarity, the description below focuses on embodiments in which the interaction products that are detected are signal electrons. The assessment apparatus 100 may comprise, for example during operation, a single beam or a plurality of beams, i.e. a multi-beam. The component beams of a multi-beam may be referred to as sub-beams or beamlets. A multi-beam may be used to scan different parts of a sample simultaneously. When the assessment apparatus 100 uses a multi-beam, the assessment apparatus 100 may assess a sample more quickly than when the assessment apparatus 100 uses a single-beam. For example, a higher throughput of sample assessment may be achieved using a multibeam assessment apparatus compared to a single beam apparatus.

The assessment apparatus 100 of Figure 1 comprises a vacuum chamber 110, a load lock chamber 120, an electron-optical apparatus 140, an equipment front end module (EFEM) 130 and a controller 150. The electron-optical apparatus 140 (also known as an electron beam apparatus or an electron apparatus) may be within the vacuum chamber 110. The electron-optical apparatus 140 may comprise an electron-optical device (described in more detail below) and an actuatable stage. It should be appreciated that reference in the description to the electron-optical elements of the electron-optical apparatus 140 can be considered to be a reference to the electron-optical device.

The EFEM 130 includes a first loading port 130a and a second loading port 130b. The EFEM 130 may include additional loading port(s). The first loading port 130a and the second loading port 130b may, for example, receive substrate front opening unified pods that contain samples. One or more robot arms (not shown) in the EFEM 130 transport the samples to the load lock chamber 120.

The load lock chamber 120 is used to remove the gas around a sample. The load lock chamber 120 may be connected to a load lock vacuum pump system (not shown), which removes gas particles in the load lock chamber 120. The operation of the load lock vacuum pump system enables the load lock chamber to reach a first pressure below the atmospheric pressure. The vacuum chamber 110, which may be a main chamber of the assessment apparatus 100, is connected to a main chamber vacuum pump system (not shown). The main chamber vacuum pump system removes gas molecules from the vacuum chamber 110 so that the pressure around the sample reaches a second pressure equal to or lower than the first pressure. Different parts of the electron-optical apparatus 140 may have different levels of pressure below the atmospheric pressure. After reaching the required pressure, the sample leaves the load lock chamber 120 and is transported to the electron-optical apparatus 140 by which it may be assessed. The electron-optical apparatus 140 may use either a single beam or a multi-beam for the assessment. Alternatively, an electron-optical device array comprising a plurality of electron-optical devices may be used, further also referred to as a multi-column electron-array, in which each electron-optical device (or each column in the multi-column array) comprises, for example during operation, either a single beam or a multi-beam.

The controller 150 is electronically connected to the electron-optical apparatus 140. The controller 150 may be a processor (such as a computer) configured to control the assessment apparatus 100. The controller 150 may also include processing circuitry configured to execute data, signal and image processing functions for example on the data set e.g. embodied as signals such as detection signals. The controller 150 may thus include processing circuitry configured to execute processing functions on signal, image and other data produced in the assessment apparatus 100. While the controller 150 is shown in Figure 1 as being outside of the structure that includes the vacuum chamber 110, the load lock chamber 120, and the EFEM 130, it is appreciated that the controller 150 may be part of the structure. The controller 150 may be located in one of the components of the assessment apparatus 100 or it may be distributed over at least two of the components.

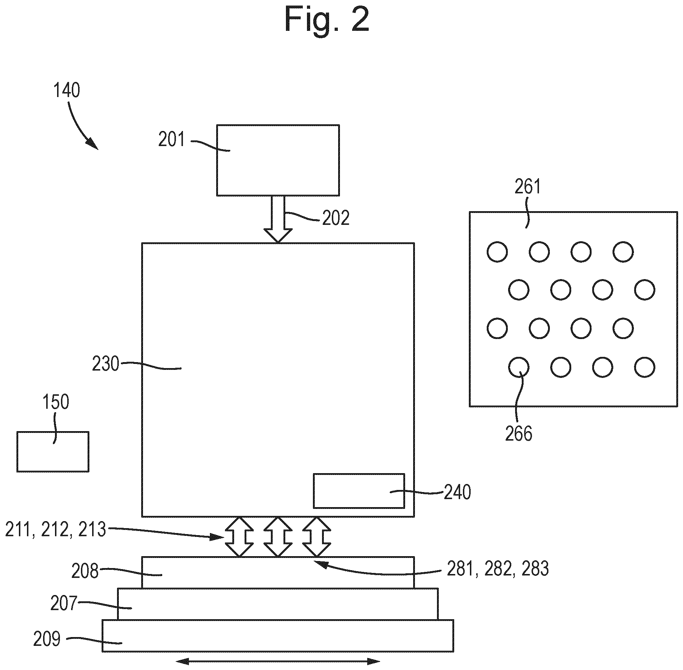

Figure 2 is a schematic diagram illustrating an exemplary electron-optical apparatus 140. The electron-optical apparatus 140 may be provided as part of the assessment apparatus 100 of Figure 1. The electron-optical apparatus 140 includes a source 201 and an electron-optical device 230 (which may also be referred to as an electron-optical column). The source 201 may comprise a cathode (not shown) and an extractor and/or anode (not shown). During operation, the source 201 is configured to emit electrons from the cathode. The electrons may be extracted or accelerated by the extractor and/or the anode to form the source beam 202.

The electron-optical device 230 may be configured to convert the source beam 202 into a plurality of primary beams 211, 212, 213 (which may be referred to as sub-beams or beamlets). The electron-optical device 230 may be configured to direct the primary beams 211, 212, 213 along respective beam paths toward a sample location for the sample 208. Although three beams are illustrated, the number of beams may be of the order of 100s or 1,000s, for example up to 20,000 per electron-optical apparatus 140. The plurality of beams may be referred to collectively as a multi-beam or a beam grid. The different beams may be arranged relative to each other across the beam grid in a pattern. The pattern of the beam grid may be referred to array. The electron-optical device 230 has a field of view which may be defined as the area of the surface of the sample 208 within which the primary beams 211, 212, 213 can scan while the aberrations of the electron-optical device 230 remain within a defined value. Alternatively, the field of view may be defined by the maximum scan range of the electron-optical device 230. The field of view may be of the order of millimeters, for example up to 20mm at the sample 208.

The electron-optical device 230 comprises a plurality of electron-optical elements positioned along the beam paths. The electron-optical elements are configured to manipulate the beams. For example, the electron-optical elements may be configured to lens, focus, deflect or correct the beams. The electron-optical elements may be arranged in at least one stack of electron-optical elements. Such an electron-optical element may be positioned upbeam or downbeam with respect to another of the electron-optical elements. The terms upbeam and downbeam relate to the direction of the beams from the source 201 to the sample 208 during use of the electron-optical device 230, which may be expressed as a direction along one or more of the beam paths. In an embodiment some of the different electron-optical elements may take a planar form, such as a plate 261. An electric field that manipulates the beams may be generated between two plates 261, e.g. by applying, in use, different potentials to neighboring/adjoining plates 261 such as along the beam path. An electric field that manipulates the beams may be generated between surfaces of plates 261 across the beam path for example between the neighboring plates 261. One or more beam apertures 266 may be defined in the plates 261 for the passage of one or more beams. The beam apertures 266 may be arranged in a pattern such as a regular grid e.g. hexagonal or square. Such a pattern of the beam apertures 266 may be referred to as an aperture array (i.e. a two-dimensional array over the surface of the plate). The pattern of the beam apertures 266 may correspond to the pattern of beams within the beam grid. Beam apertures 266 in different plates operating on the same beam(s) are typically aligned.

The electron-optical elements may comprise one or more corrector arrays. For example, a corrector array may be integrated into the shape, position and/or size of the beam apertures 266 of the plates 261. The disclosure of such a corrector array as described in WO 2022101072 A1 is hereby incorporated by reference. One or more corrector arrays may comprise multipole deflectors with a specific superposition of potentials applied across the individually controllable electrodes. The disclosure in WO2012165955 of an array of multipole deflectors is hereby incorporated by reference.

One or more of the electron-optical elements may comprise an aperture for the path of a plurality of the beams. For example, the aperture may be a macro aperture for all of the beams. The disclosures of a slit aperture for a collimator or corrector comprising strip electrodes in WO 2021156121 A1 and WO 2021204734 A1 are hereby incorporated by reference. One or more electron-optical elements may comprise one or more plate electrodes that are curved across the path of the beam grid for use as a lens array, a corrector array and/or a collimator array such as disclosed in European patent application 23211553.5 filed 22 November 2023, which is hereby incorporated by reference at least so far as the use and application of curved plate electrodes.

In the current embodiment, the electron-optical device 230 may form three probe spots 281, 282, 283 on the surface of the sample 208. The electron-optical device 230 may be configured to deflect the primary beams 211, 212, 213 so as to scan the probe spots 281, 282, 283 across individual scanning areas of the sample 208. In response to incidence of the primary beams 211, 212, 213 on the sample 208, signal electrons are generated from the sample 208 which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical apparatus 140 comprises a sample holder 207 that supports a sample 208. The sample holder 207 supports the sample 208 for assessment. The sample holder 207 is supported by an actuatable stage 209. The electron-optical apparatus 140 further comprises a detector array 240. The detector array 240 may be part of the electron-optical device 230. The detector array 240 e.g. detects signal electrons from the sample 208. The detector array 240 generates detection signals based on detection of the signal electrons.

In an embodiment, the detector array 240 may define the surface of the electron-optical apparatus 140 facing the sample 208, e.g. the bottom surface of the electron-optical device 230. There may be more than one detector array at different positions along the paths of the primary beams 211, 212, 213.

The detector array 240 may comprise a plurality of detector elements, with at least one detector element per beam. The detector elements may, for example, be charge capture electrodes, for example metal plates, which may be configured to detect at least some of the signal electrons. Alternatively or additionally, the detector elements may comprise detection diodes configured to detect at least some of the signal electrons. Alternatively or additionally, the detector elements may comprise a scintillator material (such as YAG) configured to convert signal electrons into photons that may be subsequently detected. The detector elements may be arranged around beam apertures 266 in the bottom surface of the electron-optical device 230 to allow the primary beams 211, 212, 213 to pass towards the sample 208. Each detector element may comprise a plurality of detection segments or may constitute a single sensitive surface for each beam. The detection signal generated by a detector element may be transmitted to a processor for generation of an image. For example, the detection signal may represent a grey value or an intensity value of a pixel of an image.

The detector array 240 may send the detection signals, for example as an imaging signal or a detection signal, to the controller 150 or to a signal processing system (not shown) which may be part of the controller 150. The controller 150 or the signal processing system may be configured to generate images of the corresponding scanned areas of the sample 208. The detector array 240 may be incorporated at least partly into the electron-optical device 230. Alternatively, the detector array 240 may be separate from the electron-optical device 230. For example, the electron-optical apparatus 140 may comprise a secondary electron-optical device configured to direct secondary electrons to the detector array 240. In such an embodiment, the secondary electron-optical device comprises a beam separator (such as a Wien filter, not shown). The beam separator may separate the paths of the primary electrons towards the sample 208 from the paths of the signal electrons away from the sample 208. Note, such a beam separator may be present in a different embodiment with a detector array within the electron-optical device 230 for directing the primary electrons towards the sample and the signal particles to detector elements of the detector array.

The controller 150 (for example a control system comprising distributed controllers) may be connected to various parts (e.g. components) of the electron-optical apparatus 140 of Figure 2, such as the source 201, the detector array 240, the electron-optical device 230, and the actuatable stage 209. The controller 150 may perform various image processing functions and signal processing functions. The controller 150 may also generate various control signals to govern operations of the assessment apparatus 100.

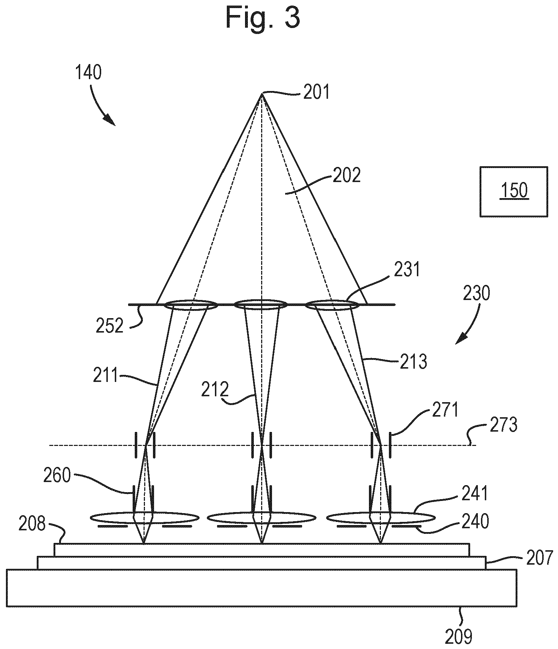

Figure 3 schematically depicts an electron-optical apparatus 140 of an assessment apparatus, e.g. the assessment apparatus 100 of Figure 1. The electron-optical apparatus 140 of Figure 3 may be the electron-optical apparatus 140 of Figure 2 in which the electron-optical elements of the electron-optical device 230 comprise a beam limiting aperture array 252, a condenser lens array 231, a collimator array 271 for example at an intermediate focus plane 273, a scan deflector array 260, an objective lens array 241 and the detector array 240.

The source 201 generates a diverging source beam 202. The beam limiting aperture array 252 defines a plurality of primary beams 211, 212, 213 from the source beam 202. The condenser lens array 231 focuses the primary beams 211, 212, 213 at the intermediate focus plane 273. The condenser lens array 231 may comprise the beam limiting aperture array 252. Alternatively, the condenser lens array 231 may be downbeam or upbeam of the beam limiting aperture array 252. The condenser lens array 231 may be electrostatic. In an alternative embodiment the condenser lens array 231 comprises a magnetic element for example as a plurality of magnetic elements / one or more magnetic elements.

The collimator array 271 is configured to collimate the primary beams 211, 212, 213 along respective beam paths towards and substantially orthogonal to a surface of the sample 208. The collimator array 271 may be located at or near the intermediate focus plane 273. The collimator array 271 may comprise a plurality of deflectors configured to deflect respective primary beams 211, 212, 213. Additionally or alternatively the collimator array 271 may comprise a lens or lens array that operates on the different beams to deflect the relative paths of the beams. The collimator array 271 may be electrostatic or magnetic. The collimator array 271 may consist of a single plate 261 comprising electrodes around the beam apertures 266, such as on the surface around the beam apertures 266 and/or on the inside of the beam apertures 266. The electrodes may cooperate as a deflector per beam aperture 266. Alternatively, the collimator array 271 may comprise a stack of plates 261. In use a potential difference is applied between the plates 261 so as to generate a lensing effect at the beam apertures 266. The plates 261 may have a curvature across the beam path. Alternatively, the collimator array 271 may comprise a plurality of layers of strip electrode deflectors as shown in WO2021156121 and WO2021204734. A layer of strip electrode deflectors may consist of a plate. Although not shown in Figure 3, in an alternative embodiment the collimator array 271 is replaced by a macro collimator configured to collimate the primary beams 211, 212, 213. The macro collimator may be a magnetic lens, or an electrostatic lens, or a combination of magnetic and electrostatic lens. In a further alternative embodiment, the electron-optical device 230 comprises a macro collimator in addition to or replacing the collimator array 271.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate to scan all of the primary beams 211, 212, 213 simultaneously in parallel across the individual fields of view of the respective objective lenses of the objective lens array 241. Alternatively, the scan deflector array 260 may comprise strip deflectors (as shown in WO2004081910, WO2021156121 and WO2021204734) configured to deflect a row of beams along the individual fields of view of the respective objective lenses of the objective lens array 241.

The objective lens array 241 is configured to focus the primary beams 211, 212, 213 onto the sample 208. The objective lens array 241 may comprise a stack of plates 261. Different potentials are applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The stack of plates 261 of the objective lens array 241 may be referred to as, or as part of, an objective lens assembly. The objective lens assembly may comprise one or more of the scan deflector array 260, a corrector array (not shown) and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241, for example as part of the bottom surface of the electron-optical device 230 facing the sample 208. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, a condenser lens array, a collimator array, an objective lens array and a detector array are hereby incorporated by reference.

The electron-optical device 230 may comprise one or more corrector arrays configured to at least partly correct one or more types of aberration of the beams. Such corrector arrays may be associated with or integrated into the condenser lens array 231, the collimator array 271 and/or the objective lens array 241, or between two of these arrays, e.g. between the condenser lens array and the collimator array.

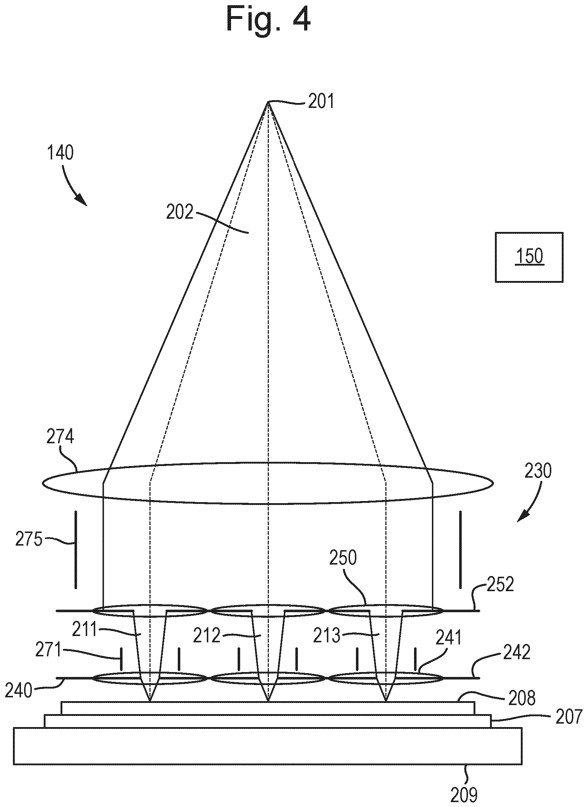

Figure 4 schematically depicts an electron-optical apparatus 140 of an assessment apparatus, e.g. the assessment apparatus 100 of Figure 1. The electron-optical apparatus 140 of Figure 4 may be the electron-optical apparatus 140 of Figure 2 in which the electron-optical device 230 comprises a macro condenser lens 274, a macro scan deflector 275, a beam limiting aperture array 252 (which may be referred to as an upper beam limiter), a control lens array 250, a collimator array 271, an objective lens array 241, a beam shaper array 242 (which may be referred to as a lower beam limiter) and the detector array 240.

The source 201 generates a diverging source beam 202. The macro condenser lens 274 is located between the source 201 and the objective lens array 241. The macro condenser lens 274 is configured to at least partly collimate the source beam 202. The macro scan deflector 275 is located between the macro condenser lens 274 and the objective lens array 241. The macro scan deflector 275 is configured to operate on the source beam 202 so that the primary beams 211, 212, 213 scan the surface of the sample 208. Additionally or alternatively the electron-optical device 230 may comprise a scan deflector array (not shown) downbeam of the control lens array 250. The macro condenser lens 274 and/or the macro scan deflector 275 may at least in part be magnetic.

The beam limiting aperture array 252 defines a plurality of primary beams 211, 212, 213 from the source beam 202. The beam shaper array 242 and the beam limiting aperture array 252 are plates 261 in which the beam apertures 266 are smaller in dimension than other plates of the electron-optical device 230. The beam apertures 266 of the beam limiting aperture array 252 define the primary beams 211, 212, 213. The beam apertures 266 of the beam shaper array 242 shape the primary beams 211, 212, 213 to at least partially correct for types of aberration in the beams.

The collimator array 271 is configured to collimate the primary beams 211, 212, 213 along respective beam paths towards and substantially orthogonal to a surface of the sample 208. The collimator array 271 may be located between the beam limiting aperture array 252 and the objective lens array 241. The collimator array 271 may be omitted. Alternatively, when the collimator array 271 is provided, then the macro condenser lens 274 may be omitted. The collimator array 271 may comprise a plurality of deflectors configured to deflect respective primary beams 211, 212, 213. The collimator array 271 may be electrostatic. The collimator array 271 may consist of a single plate 261 comprising the deflectors around the beam apertures 266, for example on the surface around the beam apertures 266 and/or on the inside of the beam apertures 266. Alternatively, the collimator array 271 may comprise a stack of plates 261. In use a potential difference is applied between the plates 261 so as to generate a lensing effect at the beam apertures 266. One or more of the plates may be curved across the path of the beam grid. Alternatively or additionally, the collimator array 271 may comprise a plurality of layers of strip electrode deflectors. A layer of strip electrode deflectors may be a plate.

The objective lens array 241 is configured to focus the primary beams 211, 212, 213 onto the sample 208. The objective lens array 241 may comprise a stack of plates 261. In use, different potentials may be applied to respective plates 261 so as to generate electrostatic fields between adjacent plates 261. The electrostatic fields generate electrostatic lenses that may be configured to focus the primary beams 211, 212, 213. The objective lens array 241 may be proximate the sample 208.

The control lens array 250 may be upbeam of the objective lens array 241. The control lens array 250 may comprise a stack of plates 261, for example at least three plates 261. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241. The control lens array may provide one or more additional degrees in electron-optical freedom such as in pre-focusing, magnification and beam current setting.

The stack of plates 261 of the objective lens array 241 may be referred to as an objective lens assembly. The objective lens assembly may comprise one or more of the beam limiting aperture array 252, the control lens array 250, a corrector array (not shown), the collimator array 271, the beam shaper array 242 and the detector array 240 in addition to the objective lens array 241. The objective lens assembly may comprise additional plates having lens functionality providing additional degrees of electron-optical freedom. A control lens array may be comprised by such an additional plate.

In an embodiment the detector array 240 may be integrated into the objective lens array 241. Alternatively (or additionally) the detector array 240 may be upbeam of the bottom surface of the electron-optical device 230. For example, the detector array 240 may be within the objective lens assembly or even upbeam of the objective lens assembly. For example, the detector array 240 may be in or upbeam of the objective lens array 241.

The disclosures in EP 3869535 A1 and WO 2021165136 A1 of a source, an objective lens array and a detector array are hereby incorporated by reference. The disclosure in WO2022058252 A1 of the collimator array, the macro condenser lens, the macro scan deflector, and the need for a beam limiting aperture array and a beam shaper array is incorporated by reference.

The electron-optical device 230 may comprise one or more corrector arrays (not shown) configured to at least partly correct one or more types of aberration of the beams. Such corrector arrays may be associated with or integrated into the control lens array 250, the collimator array 271 and/or the objective lens array 241, for example as part of the objective lens assembly.

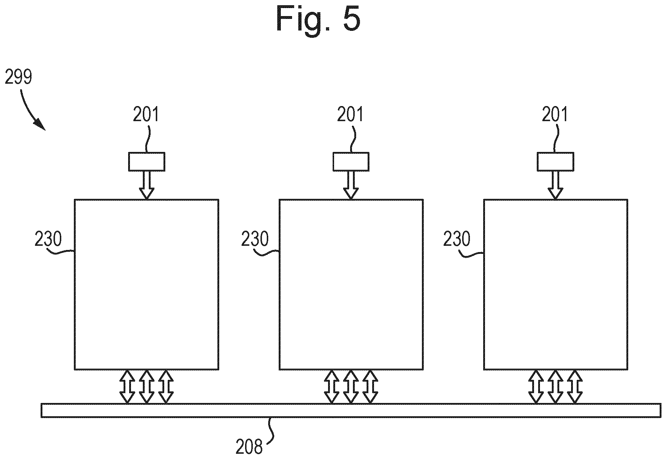

Figure 5 schematically depicts an electron-optical device array 299. In an embodiment the assessment apparatus 100 of Figure 1 comprises the electron-optical device array 299 instead of the electron-optical apparatus 140. Such an electron-optical device array 299 is also referred to as a multi-column array. The different columns (or electron-optical devices 230) may comprise in use a plurality of beams such as a beam grid. In an embodiment the electron-optical device array 299 comprises a plurality of electron-optical devices 230 of the type shown in Figure 2.

In an embodiment, one or more electron-optical elements may be shared between more than one of the electron-optical devices 230 of the electron-optical device array 299. The electron-optical elements may comprise one or more plates 261 in which a plurality of beam apertures 266 are defined for respective beam paths. In an embodiment, one or more sources 201 may be shared between more than one of the electron-optical devices 230 of the electron-optical device array 299. The sources may be comprised in a source array having different sources generating a source beam for different respective electron-optical device 230.

The electron-optical devices 230 may focus respective multi-beams simultaneously onto different regions of the same sample 208. In a different embodiment, the electron-optical devices 230 of the electron-optical device array 299 may project respective single beams towards the sample 208.

Each electron-optical device 230 of the electron-optical device array 299 may be configured in any of the ways described herein. The disclosure in WO 2022008286 A1 of how the objective lens is incorporated and adapted for use in the multi-device arrangement is hereby incorporated by reference. The disclosure in WO 2021165135 A1 of a multi-device arrangement of a multi-beam device comprising a collimator at, or proximate to, an intermediate focus is hereby incorporated by reference.

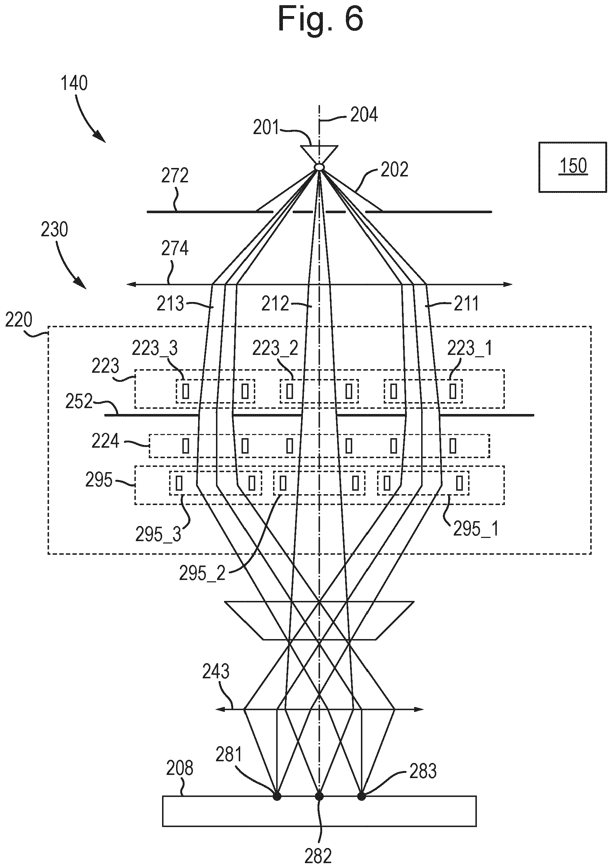

Figure 6 schematically depicts an electron-optical apparatus 140 of an assessment apparatus, e.g. the assessment apparatus 100 of Figure 1. The electron-optical apparatus 140 comprises an electron-optical device 230. The field of view of the electron-optical device 230 may be, for example, of the order of 100s of microns across the primary beams 211, 212, 213 at the sample 208. The electron-optical apparatus 140 of Figure 6 may be the electron-optical apparatus 140 of Figure 2 in which the electron-optical device 230 comprises a Coulomb aperture array 272, a macro condenser lens 274, a source converter (or micro-optical array) 220 and an objective lens 243. The electron-optical apparatus 140 defines an electron-optical axis 204. The Coulomb aperture array 272 may be referred to as a beam former array.

The source 201 generates a source beam 202. The Coulomb aperture array 272 defines a plurality of primary beams 211, 212, 213 from the source beam 202. The Coulomb aperture array 272, in operation, is configured to block off peripheral electrons to reduce electron-electron interactions (also referred to as Coulomb interactions) that may generate aberrations.

The macro condenser lens 274 is configured to at least partly collimate the primary beams 211, 212, 213. In an embodiment the macro condenser lens 274 is magnetic. The macro condenser lens 274 may be a non-rotational condenser lens. In an embodiment the macro condenser lens 274 is configured to operate on a plurality of, optionally all of, the primary beams 211, 212, 213.

The source converter 220 is configured to convert the primary beams 211, 212, 213 transmitted by the Coulomb aperture array 272 into the beams that are directed towards the sample 208. In an embodiment the source converter 220 is a module. Alternatively, the source converter 220 may comprise a plurality of separate electron-optical elements.

In an embodiment the source converter 220 comprises a pre-bending deflector array 223 with pre-bending deflectors 223_1, 223_2, 223_3 configured to deflect respective primary beams 211, 212, 213 toward a beam limiting aperture array 252.

In an embodiment the source converter 220 comprises a beam limiting aperture array 252 with an aperture pattern (i.e. apertures arranged in a formation) configured to define the outer dimensions of the primary beams 211, 212, 213 directed towards the sample 208. The beam limiting aperture array 252 may be a plate 261. In an embodiment, the beam limiting aperture array 252 defines a plurality of beams from each of the primary beams 211, 212, 213 directed to the beam limiting aperture array 252. In an alternative embodiment, the beam limiting aperture array 252 maintains the number of the primary beams 211, 212, 213 incident on the beam limiting aperture array 252.

The source converter 220 may comprise a corrector array such as an aberration reduction array 224 configured to reduce aberrations of the primary beams 211, 212, 213. In an embodiment the aberration reduction array 224 comprises a plurality of lenses configured to operate on respective primary beams 211, 212, 213. The aberration reduction array 224 may, for example, comprise a field curvature compensator array (not shown) comprising lenses. The aberration reduction array 224 may comprise an astigmatism compensator array (not shown) comprising stigmators. The stigmators may, for example, be controlled to operate on the primary beams 211, 212, 213 to reduce astigmatism aberrations.

The source converter 220 may comprise a deflector array 295 comprising deflectors 295_1, 295_2, 295_3 for the beam paths of respective primary beams 211, 212, 213. The deflectors 295_1, 295_2, 295_3 are configured to deflect the beam paths of the primary beams 211, 212, 213 towards the front focal plane of the objective lens 243 to ensure that the individual primary beams 211, 212, 213 will impinge on the sample 208 substantially perpendicular.

In an embodiment the objective lens 243 is magnetic. In an embodiment the objective lens 243 is a macroscopic lens configured to manipulate a plurality of, optionally all of, the primary beams 211, 212, 213 simultaneously. The objective lens 243 focuses the primary beams 211, 212, 213 onto the surface of the sample 208. The primary beams 211, 212, 213 form respective probe spots 281, 282, 283 on the surface of the sample 208. The deflectors 295_1, 295_2, 295_3 of the deflector array 295 deflect the individual primary beams 211, 212, 213 to the front focal plane of the objective lens to ensure that the individual primary beams 211, 212, 213, in use, impinge on the substrate 208 substantially perpendicular. In an embodiment the objective lens 243 is a macroscopic lens containing both magnetic and electrostatic lenses. In such an embodiment the macroscopic electrostatic lenses manipulate the plurality of the primary beams 211, 212, 213 simultaneously. In a further embodiment, the objective lens 243 comprises one or more scan deflectors (electrostatic and/or magnetic) to scan the plurality of primary beams 211, 212, 213 over the substrate 208.

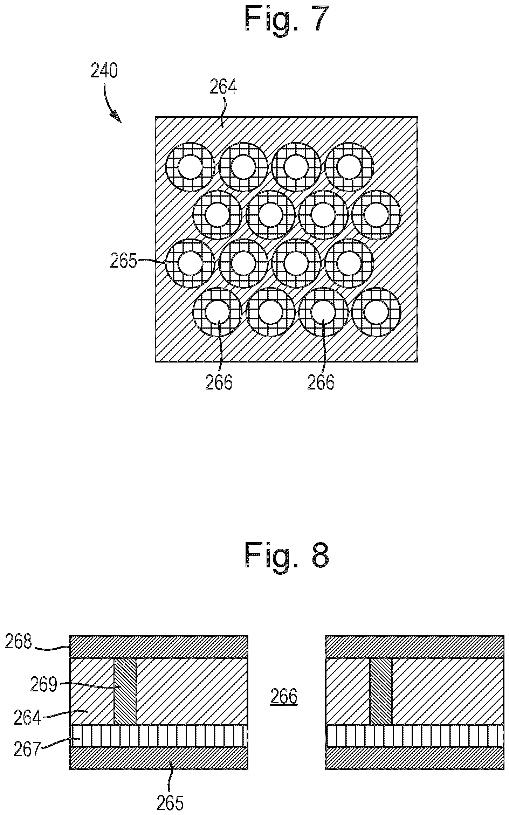

Figure 7 is a bottom view of the detector array 240 which comprises a detector substrate 264 on which are provided a plurality of detector elements 265 each surrounding a beam aperture 266. The detector array 240 may be provided at a downbeam surface of a plate 261 comprising beam apertures 266. In an embodiment, the detector elements 265 are charge capture electrodes, for example metal plates. The beam apertures 266 may be formed by etching through the detector substrate 264. In the arrangement shown in Figure 7, the beam apertures 266 are in a hexagonal close packed array. The beam apertures 266 can also be differently arranged, e.g. in a rectangular array.

Figure 8 depicts at a larger scale a part of the detector array 240 in cross section. The detector elements 265 form the bottom surface, i.e. the surface the closest to the sample 208, of the detector array 240. Between the detector elements 265 and the main body of the detector substrate 264 a logic layer 267 may be provided. At least part of the signal processing system, for example for amplification, may be incorporated into the logic layer 267.

A wiring layer 268 is provided on the backside of, or within, the detector substrate 264 and connected to the logic layer 267 by through-substrate vias 269. The number of through-substrate vias 269 need not be the same as the number of beam apertures 266. In particular if the electrode signals are digitized in the logic layer 267 only a small number of through-silicon vias may be required to provide a data bus. The wiring layer 268 may include control lines, data lines and power lines. It will be noted that in spite of the beam apertures 266 there is ample space for all necessary connections. The detector array 240 may be fabricated using CMOS technology, but may also be fabricated using bipolar or other manufacturing techniques. A printed circuit board and/or other semiconductor chips may be provided on the detector array 240.

Features in electron-optical plates may be manufactured using techniques from microelectromechanical systems (MEMS) (i.e. using MEMS manufacturing techniques). MEMS are miniaturized mechanical and electromechanical elements that are made using microfabrication techniques. Merely as an example, a collimator array may be formed using MEMS manufacturing techniques so as to be spatially compact. As another example, a scan deflector array may be formed using MEMS manufacturing techniques.

As indicated before, illumination with light (e.g. stimulation light) on an area to be scanned with the primary beam or probe beam of charged particles (before or during the scanning) may enhance the contrast in some defect inspection methods. It may be difficult to direct stimulation light to the sample surface. For example, dimensions in some types of pattern inspection tools may make it difficult to reach the sample with the light beam, e.g. directing a light beam onto the scanning area from an edge of the electron-optical device 230. Some known means for guiding the stimulation light along the sample surface may accumulate charge in use, which may affect the quality of the primary charged particle beam. An embodiment of the present invention provides an electron-projection device at least partially integrated into the electron-optical device 230 for projecting at least one charged particle beam towards a sample, wherein the charge build-up on the sample surface may be avoided without affecting the stability of the primary charged particle beam. The present invention may be implemented with MEMS-based multi beam systems.

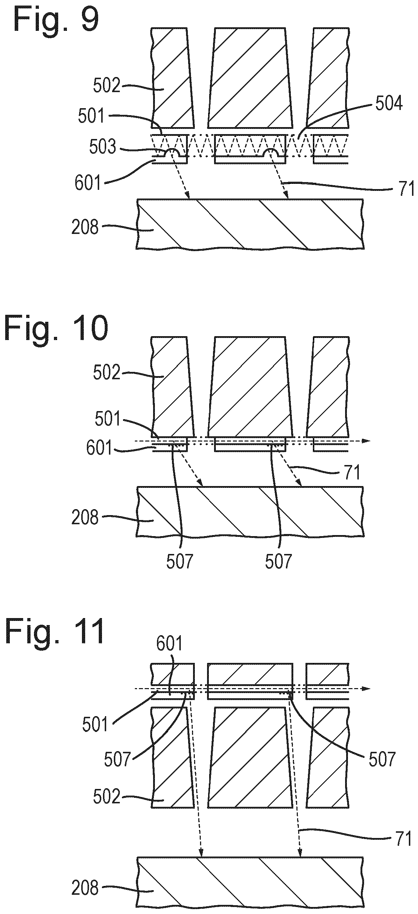

According to an embodiment of the present invention, and as shown in Figures 9 to 13, there is provided an electron-optical projection device 230 for projecting at least one charged particle beam towards sample 208, the device comprising: a beam directing element 502 configured to project (or at least configured to contribute to project) the at least one charged particle beam towards a sample location on the sample. The electron-optical projection device 230 further comprises an optical member 501 configured to guide (in other words, configured to direct) stimulation light 71 and further comprises outcoupling features 503, 507 such as a dimple 503 (see Fig. 9) or diffraction gratings 507 (see Fig. 10 and 11) to direct the stimulation light 71 towards the sample so that the stimulation light 71 is at least partially coincident with the at least one charged particle beam. The optical member 501 comprises a first surface facing down-beam. At least part of the first surface comprising a coating layer 601 being at least partially transparent for the stimulation light and being electrically conductive.

Conductivity is a material property indicating the ease of passing an electrical current through the material. Conductance relates to the ease of passing current through an object.

Transparency of a material or an object is a measure indicating the level of light scattering and/or light absorption when the light passes through the material or object. High transparency indicates that a relatively high proportion of light is transmitted without being scattered and/or absorbed. Low transparency indicates a relatively low proportion of light is transmitted, because a high proportion of light is scattered and/or absorbed.

The optical member 501 is a member which guides light along the surface of the sample. For example, optical member 501 may be a photonics layer such as an optical wave guide, e.g. an integrated photonic waveguide as described in WO2024088718A1.

The coating layer 601 is electrically conductive, meaning it may reduce or prevent charge build up on the optical member 501 or any other component of the electron-optical projection device 230. The coating layer 601 at least partially covers the optical member 501, or coating layer 601 may fully cover optical member 501. Any charge build-up on optical member 501, which may cause deterioration of the primary electron beam, may be dissipated via the coating layer 601.

The coating layer 601 is at least partially transparent, so that it does not prevent the stimulation light 71 from being projected to the sample 208. Optical transparency may be particularly important in regions of the coating layer 601 which cover outcoupling features 503, 507 that direct the stimulation light from the optical member 501 to the sample 208. Accordingly, the coating layer 601 does not prevent the stimulation light 71 from reaching the sample 208. The transparency of the coating layer 601 may vary across the surface of the optical member.

For example, in Figure 9, optical member 501 comprises outcoupling features 503 which outcouple stimulation light 71 from the optical member 501 to the sample 208. Coating layer 601 is disposed over the optical member 501 so that any build of electrical charge, e.g. from particles generated by sample 208 during scanning (or charge build-up caused by other means) is dissipated away. The outcoupling feature 503 may for example be a dimple 503 in the optical member 501.

A path followed by the stimulation light 71 is indicated schematically with a dashed line in Figures 9-13.

The coating layer 601 may be provided in an electron-optical projection device 230 having other configurations of the optical member 501. For example, the embodiment shown in Figure 10 comprises an optical member 501 comprising diffraction gratings 507 disposed thereon as the out-coupling feature.

The configuration of the coating layer 601 is not limited, as long as the coating layer 601 may dissipate any charge build-up on the optical member 501 while permitting stimulation light 71 to pass to the sample 208. For example, Figure 11 shows an electron-optical projection device 230 wherein the optical member 501 and coating layer 601 are each disposed up-beam of the beam directing element 502. The beam directing element 502 is configured such that the stimulation light 71 may travel to the sample 208 via the same aperture as the charged-particle beam.

The coating layer 601 may be disposed so that it does not obstruct the charged particle beam. In other words, the coating layer 601 does not cover an aperture of the beam directing element though which the at least one charged particle beam is projected.

The coating layer 601 may be continuous over the down-beam surface of optical member 501. This may lead to particularly effective charge dissipation from the surface of optical member 501. Alternatively, the coating layer 601 may be discontinuous, i.e. a plurality of electrically-disconnected coating layer regions may be provided on the surface of the optical member 501. Each of the coating layer regions may be electrically grounded, so that each of them can enable dissipation of electrical charge build-up.

The coating layer 601 may be disposed over the whole area of the first surface. This embodiment may be particularly advantageous, as the build-up of charge can be prevented across a whole area of the optical member 501.

The coating layer 601 may be electrically grounded, so that any built-up charge may be transferred away from the electron-optical projection device 230.

The coating layer 601 may reduce or prevent a build-up of charge on the optical member.

The coating layer 601 may be a transparent conducting film. The coating layer 601 may be a transparent plate. The skilled person will appreciate that the architecture and composition of the coating layer 601 may vary, as long as the coating layer prevents or reduces charge build-up on the optical member 501 and enables passage of the stimulation light 71 to the sample 208.

For example, the coating layer 601 may have a multi-layer structure.

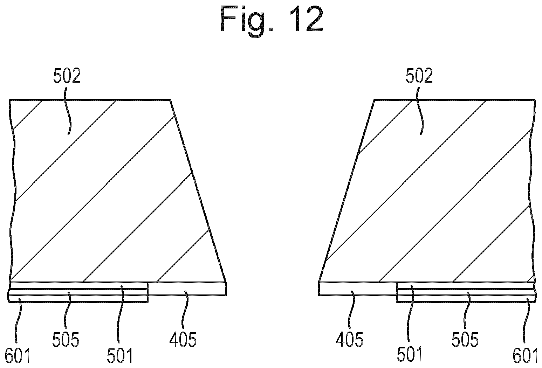

Figure 12 shows an example of the present disclosure, wherein the optical element 501 comprises a multi-layer structure comprising additional layer 505 disposed between the optical member 501 and coating layer 601.

The coating layer 601 may be disposed so that it does not cover a detector element 405 provided on a surface of the electron-optical projections device. Detector element 405 may directly detect the charged-particles emitted by sample 208, without the need for the emitted particles to travel through any further optical component. Accordingly, the energies of the emitted particles may be preserved, leading to a more accurate reading.

In some embodiments, the coating layer 601 may be provided over at least a portion of the detector element 405, if the coating layer 601 is selected so that it does not significantly affect the energies of the emitted particles. The detector element 405 in Figure 12 may be a detector element 265, described with reference to Figure 7. The coating layer 601 is not electrically connected to the detector element 405, so that emitted particles incident on the detector layer 405 are not conducted away from the detector layer 405. In an embodiment, each of the optical member 501 and the optional additional layer 505 are not electrically connected to the detector element 405.

While Figure 12 shows the optical member 501 and the additional layer 505 in contact with the detector layer 405, these may be separated by a gap or an insulating element, so that the detector layer is not connected tot optical member 501, another layer 501 and the coating layer 601.

The coating layer 601 may partially cover the detector element 405, provided that the detector element 405 is not electrically grounded via the coating layer 601. This may be achieved by means of a gap between the coating layer 601 on detector element 405 and the coating layer 601 on the additional layer 505. When coating layer 601 partially covers the detector element 405, the coating layer 601 may prevent oxidation of the detector element 405.

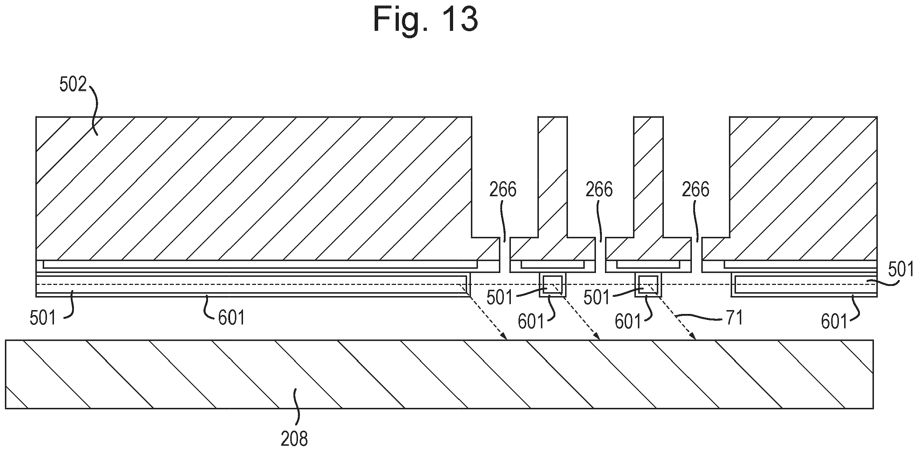

Figure 13 shows an example so the electron-optical projection device 230 comprising multiple beam directing elements 502 each configured to project a charged particle beam to the sample 208 via apertures 266. In an embodiment, the optical element 501 directs stimulation light 71 to a surface of the sample 208 at least partially overlapping with an area of the sample having a charged-particle beam projected thereon. In other words, the stimulation light 71 is directed to land on a surface of the sample 208 below the beam aperture 266. In an embodiment, the stimulation light 71 is directed so that it covers an entire surface of the sample 208 which has a charged particle beam projected thereon. Surface charge build-up on the sample 208 may be particularly high in regions having a charged-particle beam projected thereon, and most or all of the stimulated light may be concentrated in these areas.

The coating layer 601 may be disposed to surround the optical member 501.

The coating layer 601 may be at least partially constituted of a material selected from a group consisting of: polymers, metals, metal oxides, ceramics, carbon.

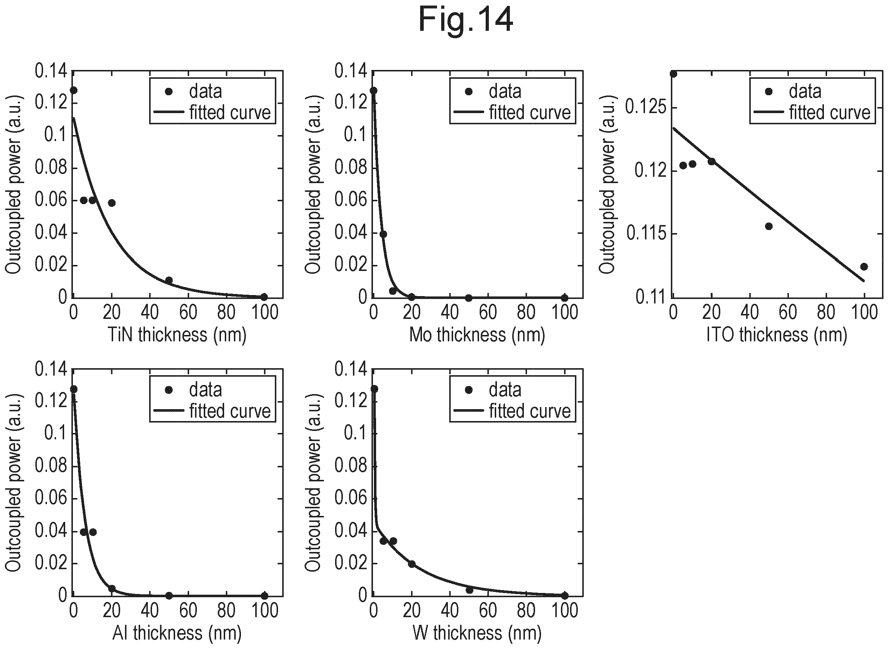

The thickness of the coating layer 601 may be selected based on the coating layer material. Figure 14 shows the outcoupling power of various materials , where x-axis notes the coating thickness, ranging from no coating (x=0) to a 100 nm thick coating: titanium nitride (TiN), aluminum, molybdenum, tungsten, indium tin oxide (ITO). A material having a higher outcoupling power for a given thickness may be preferable. The thickness may be selected so that the electrical conductivity is high enough to reduce or prevent charge build up but so that the optical transparency is sufficiently high to enable passage of the stimulation light.

The thickness may depend on the wavelength of stimulation light used. For example, the coating layer 601 (such as a transparent plate) may have a thickness greater than twice the wavelength of the stimulation light. The thickness may, for example, be in the range of from 5 µm to 50 µm. A coating layer 601 which is significantly thicker than 50 µm may be difficult to fit into the space available in an electron-optical projection device 230, and a coating thinner than 5 µm may not have suitably high conductance to enable effective charge dissipation.

The electron-optical projection device 230 may be configured to scan the at least one charged particle beam over a scan area of the sample location, and the optical member may comprise at least one out-coupling feature configured for directing stimulation light towards the sample to at least partially overlap the scan area. The outcoupling feature 503, 507 is a feature which redirects a portion of the stimulation light 71 from the optical element 501 to the sample 208. The outcoupling feature 503, 507 may comprise a reflective element, a diffraction grating, or any other suitable element which may redirect light. In an embodiment, the electron-optical projection device 230 may have a plurality of outcoupling features 503, 507, for example disposed in the vicinity of a beam directing element 502 so that stimulation light 71 may be guided to areas of the sample 208 having an charged-particle beam projected thereon. The outcoupling features of the electron-optical projection device 230 may be different or may all be the same.

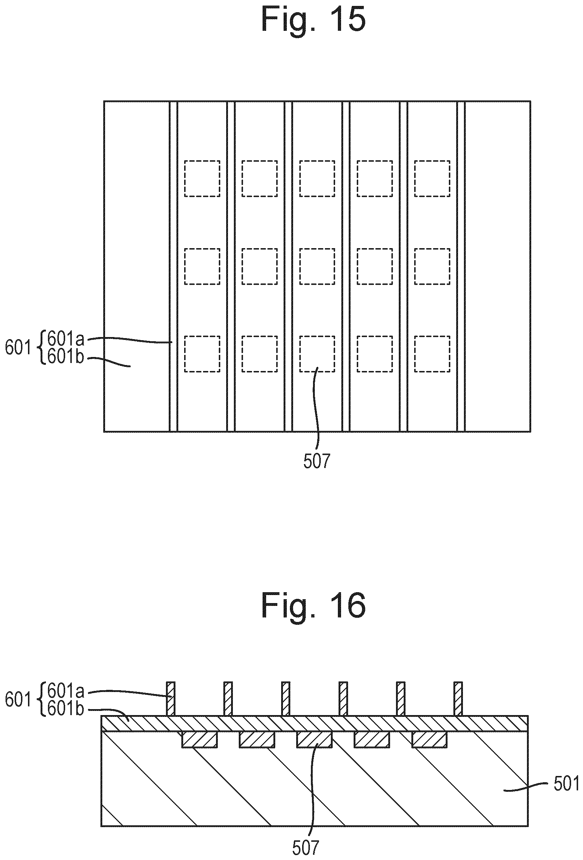

The coating layer 601 may be composed of a single material, or it may be comprised a plurality of different materials. The coating layer 601 may be composed of different materials selected for their optical transparency and ability to dissipate charge. Various possible patterns of the coating layer 601 are described with reference to Figures 15-19.

In an embodiment, the coating layer 601 comprises a first layer 601a and a second layer 601b.

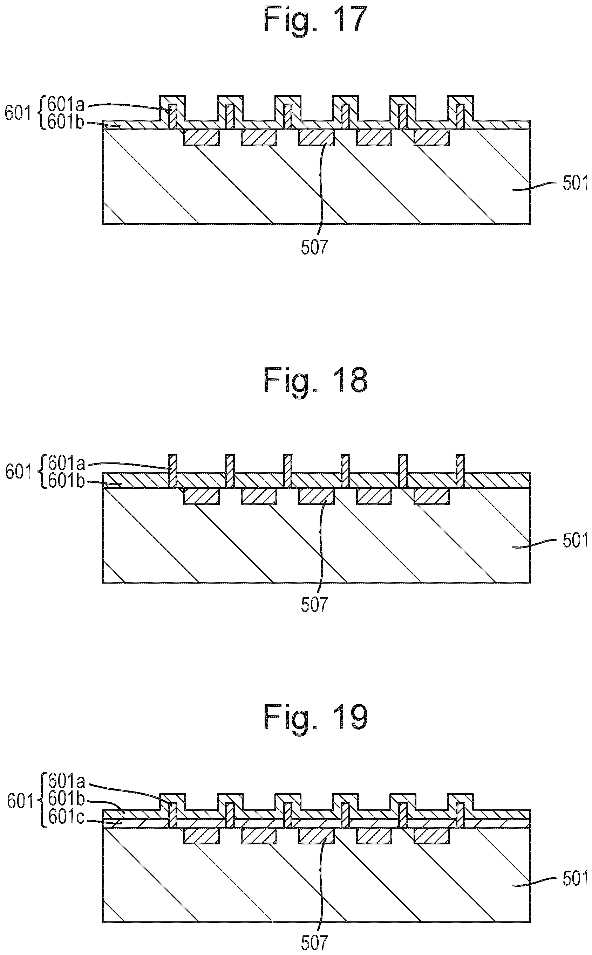

The first layer 601a may be disposed as a pattern on the first surface of the optical member 501, the first layer 601a being disposed so that it does not obstruct the at least one out-coupling feature 503, 507. The second layer 601b may be disposed to cover the first layer 601a and the at least one out-coupling feature 507. An example of this embodiment is shown in Figure 17, wherein tracks of first layer 601a are disposed along the surface of the first surface so that the tracks do not obstruct the outcoupling features 507. The second layer 601b is disposed in the regions between the tracks.

The first layer 601a may have a higher conductance than the second layer 601b. Materials having a higher conductance may be associated with a lower optical transparency. For example, metal tracks may have a relatively high conductance but relatively low optical transparency. Some materials having a high optical transparency may have low conductance.

A coating layer 601 having regions of high conductance which do not obstruct the outcoupling feature 507 ensures that built up charge may be dissipated effectively without preventing stimulation light from being outcoupled from the outcoupling feature 507. Providing regions of high optical transparency across the remaining parts of the surface ensures that any built up charge may be dissipated towards the high-conductance regions, while enabling passage of stimulation light 71 to the sample surface.

Figure 16 shows a plan view of a coating layer comprising tracks of the first layer 601a. Tracks may comprise substantially straight and parallel lines of the first layer 601a running across the surface of the first surface. Design parameters of the tracks such as their spacing and width may be varied.

The pattern of the first layer 601a may be something other than tracks. For example, the pattern may be a mesh, i.e. a network of intersecting tracks. The tracks may be arranged in directions which are substantially perpendicular to each other.

The coating layer 601 may comprise a first layer 601a and a second layer 601b, the first layer 601a being disposed as a pattern on top of a continuous second layer 601b and the first layer 601a being disposed so that it does not obstruct the at least one outcoupling feature 507. An example of this embodiment is illustrated schematically in Figure 16, which shows a cross-sectional view of the electron-optical projection device surface. When in use in an electron-optical projection device 230, the coating layer 601 is disposed to face the sample 208.

The first layer 601a may extend from the surface of the of the second layer 601b, as shown in Figure 16. The height may be varied, to ensure that the first layer 601a has sufficiently high electrical conductance while allowing most of all of the intensity of stimulation light 71 to be outcoupled to the sample 208.

In another embodiment, the first layer 601a extends from the first surface of the optical member 501, with the second layer disposed in the gaps between the first layer 601a. An example of this embodiment is shown in Figure 18.

Optionally, the coating layer 601 may comprise other layers. For example, Figure 19 shows an embodiment wherein the first layer 601a forms a pattern on the first surface that does not obstruct the outcoupling features 507, a third layer 601c is disposed in the gaps formed by the first layer 601a, and a continuous second layer 601b is provided to cover the first layer 601a and the third layer 601c. The materials of the first layer 601a, second layer 601b and third layer 601c may be selected to achieve a balance of high optical transmission of light and high electrical conductance of the coating layer 601.

The coating layer 601 may be used with an optical member 501 comprising various outcoupling features 505, 507, such as reflective elements, diffraction grating, etc. The coating layer 601 may be disposed to cover the outcoupling feature 503, 507 so that a surface of the coating layer 601 facing the sample 208 is flat. In another embodiment, the coating layer 601 may be disposed on the outcoupling feature so that a surface of the coating layer 601 facing the sample 208 follows the profile of the out-coupling feature. In an example, the coating layer 601 may follow the profile of a diffraction grating it covers. This may improve the effective optical transmission of the coating layer 601.

The electron-optical projection device 230 may be configured to project a plurality of charged particle beams towards the sample 208. Each of the at least one charged particle beam may scan a respective area of the sample. Each of the at least one aperture has an optical member disposed adjacent to it, the optical member being configured to direct stimulation light towards an area of the sample illuminated by a charged particle beam through the aperture.

Each of the charged particle beams may scan a respective area of the sample 208. A detector element may be disposed in the vicinity of each of the charged particle beams, the detector element being configured to detect charged particles generated by the area being scanned by said charged particle beam. Outcoupling features 503, 507 of optical member 501 may be arranged so that the stimulation light overlaps with each of the charged particle beams and/or with the respective surface being scanned. The coating layer 601 may be arranged on the optical member 501 to improve the proportion of stimulation light with is outcoupled, while preventing or reducing charge build-up. Accordingly, the charged particle beam is not disturbed by built-up charge and readings from the sample are not affected by charging of the optical member 501, while preventing build-up of charge on sample 208.

For example, referring to Figure 7, outcoupling features 507 (not shown in Fig. 7) and a coating layer 601 (not shown in Fig. 7) may be disposed to cover detector surface 264 to flood the sample surface with illumination light while preventing build-up charge. This may improve the image quality obtained from the readings of detector elements 265.

The beam directing element may comprise a stack of plates comprising at least one aperture configured to interact with the at least one charged particle beam to project the at least one charged particle beam towards the sample location on the sample. The at least one aperture may project one charged particle beam to the sample. The outcoupling feature(s) 503, 507 and coating layer 601 may be disposed around each of the apertures to reduce or prevent charging of the optical member 501, thus preventing disturbance of the charged-particle beam.

The electron-optical device disclosed herein may be provided in electron-optical device 230. The electron-optical device 230 may be configured to project a plurality of charged particle beams to the sample 208, or the electron-optical device 230 may be configured to project a single charged-particle beam to the sample 208.

While specific embodiments of the invention have been described above, it will be appreciated that the invention may be practiced otherwise than as described. The descriptions above are intended to be illustrative, not limiting. Thus, it will be apparent to one skilled in the art that modifications may be made to the invention as described without departing from the scope of the claims set out below.

Embodiments include the following numbered clauses:
1. An electron-optical projection device for projecting at least one charged particle beam towards a sample, the device comprising:
   a beam directing element configured to project the at least one charged particle beam towards a sample location on the sample,
   wherein the electron-optical projection device further comprises an optical member configured to direct stimulation light towards the sample so that the stimulation light is at least partially coincident with the at least one charged particle beam,
   wherein the optical member comprises a first surface facing down-beam, at least part of the first surface comprising a coating layer being at least partially transparent for the stimulation light and being electrically conductive to reduce build-up of charge on the optical member.
2. The device according to clause 1, wherein the coating layer is disposed over the whole area of the first surface.
3. The device according to any of the preceding clauses, wherein the coating layer is electrically grounded.
4. The device according to any of the preceding clauses, wherein the coating layer is configured to reduce build up of charge on the optical member.
5. The device according to any of the preceding clauses wherein the coating layer comprises a transparent conducting film.
6. The device according to any of the preceding clauses, wherein the coating layer comprises a multi-layer structure.
7. The device according to any of the preceding clauses, wherein the coating layer is also provided on at least part of a second surface of the optical member, wherein the second surface faces up-beam.
8. The device according to any of the preceding clauses, wherein the coating layer is at least partially constituted of a material selected from a group: polymers, metals, metal oxides, ceramics, carbon.
9. The device according to any of the preceding clauses, wherein the optical member comprises a transparent plate or an optical wave guide.
10. The device according to clause 9, where the transparent plate or the optical wave guide has a thickness greater than twice the wavelength of the stimulation light and/or the thickness is in a range of from 5 µm to 50 µm.
11. The device according to any of the preceding clauses, wherein the electron-optical projection device is configured to scan the at least one charged particle beam over a scan area of the sample location, and wherein the optical member comprises at least one out-coupling feature configured for directing stimulation light towards the sample to at least partially overlap the scan area.
12. The device according to clause 11, wherein the coating layer is disposed to cover the at least one out-coupling feature.
13. The device of clause 11 or clause 12, wherein the at least one out-coupling feature comprises a reflective element.
14. The device of clause 11 or clause 12, wherein the out-coupling feature comprises a diffraction grating.
15. The device according to any of clauses 11-14, wherein the coating layer comprises a first layer and a second layer, wherein:
   the first layer is disposed as a pattern on the first surface of the optical member, the first layer being disposed so that it does not obstruct the at least one out-coupling feature; and
   the second layer is disposed in gaps formed by the pattern of the first layer to cover the at least one out-coupling feature.
16. The device according to any of clauses 11-14, wherein the coating layer comprises a first layer and a second layer, wherein:
   the first layer being disposed as a pattern on the first surface of the optical member, the first layer being disposed so that it does not obstruct the at least one out-coupling feature; and
   the second layer is disposed to cover the first layer and the at least one out-coupling feature.
17. The device according to any of clauses 11-14, wherein the coating layer comprises a first layer and a second layer, the first layer being disposed as a pattern on top of a continuous second layer and the first layer being disposed so that it does not obstruct the at least one outcoupling feature.
18. The device according to any one of clauses 14-17, wherein the first layer has a higher conductance than the second layer.
19. The device according to any one of clauses 14-18, wherein the first layer has a lower transmittance than the second layer.
20. The device according to any one of clauses 14-19, wherein the pattern comprises tracks.
21. The device according to any one of clauses 14-19, wherein the pattern comprises a mesh.
22. The device of any one of clauses 11-21, wherein the coating layer disposed on the out-coupling features follows the profile of the out-coupling feature.
23. The device of any one of clauses 11-21, the coating layer being configured to face the sample, wherein the coating layer disposed on the out-coupling feature is flat.
24. The device according to any of the preceding clauses, wherein the electron-optical projection device is configured for projecting a plurality of charged particle beams towards the sample, and wherein the optical member is configured to direct stimulation light towards the sample so that the stimulation light is at least partially coincident with the plurality of charged particle beams.
25. The device according to any of the preceding clauses, wherein the beam directing element comprises a stack of plates comprising at least one aperture configured to interact with the at least one charged particle beam to project the at least one charged particle beam towards the sample location on the sample.
26. The device according to clause 25, wherein the beam directing element is configures to project one charged particle beam per aperture.
27. The device according to clause 25 or clause 26, wherein each of the beam directing element is configured to each of the at least one of the charged particle beams to scans a respective area of the sample.
28. The device according to one of clauses 25-27, wherein each of the at least one aperture has an optical member disposed adjacent to it, the optical member being configured to direct stimulation light towards an area of the sample illuminated by a charged particle beam through the aperture.

### List of reference numerals:

71 light
100 assessment apparatus
110 vacuum chamber (main chamber)
120 load lock chamber
130 EFEM
130a first loading port
130b second loading port
140 electron-optical apparatus (electron beam apparatus, electron apparatus)
150 controller
201 source
202 source beam
204 electron-optical axis
207 sample holder
208 sample
209 actuatable stage
211, 212, 213 primary beams (sub-beams, beamlets)
220 source converter (micro-optical array)
223 pre-bending deflector array
224 aberration reduction array
230 electron-optical device (electron-optical column)
231 condenser lens array
240 detector array
241 objective lens array
242 beam shaper array
243 objective lens
250 control lens array
252 beam limiting aperture array
260 scan deflector array
261 plate
264 detector substrate
265 detector elements
266 beam apertures
267 logic layer
268 wiring layer
269 through-substrate vias
270 macro collimator
271 collimator array
272 Coulomb aperture array
273 intermediate focus plane
274 macro condenser lens
275 macro scan deflector
281-283 probe spots
295 deflector array
299 electron-optical device array
405 detector element
501 optical member
502 beam directing element
503 outcoupling feature (dimple)
504 holes
505 another layer
507 outcoupling feature (diffraction grating)
601 coating layer
601a first layer 601b second layer
601c third layer

## Claims

1. An electron-optical projection device for projecting at least one charged particle beam towards a sample, the device comprising:
a beam directing element configured to project the at least one charged particle beam towards a sample location on the sample,
wherein the electron-optical projection device further comprises an optical member configured to direct stimulation light towards the sample so that the stimulation light is at least partially coincident with the at least one charged particle beam,
wherein the optical member comprises a first surface facing down-beam, at least part of the first surface comprising a coating layer being at least partially transparent for the stimulation light and being electrically conductive to reduce build-up of charge on the optical member.

2. The device according to claim 1, wherein the coating layer is disposed over the whole area of the first surface.

3. The device according to any of the preceding claims wherein the coating layer comprises a transparent conducting film.

4. The device according to any of the preceding claims, wherein the coating layer is at least partially constituted of a material selected from a group: polymers, metals, metal oxides, ceramics, carbon.

5. The device according to any of the preceding claims, wherein the optical member comprises a transparent plate or an optical wave guide.

6. The device according to claim 5, where the transparent plate or the optical wave guide has a thickness greater than twice the wavelength of the stimulation light and/or the thickness is in a range of from 5 µm to 50 µm.

7. The device according to any of the preceding claims, wherein the electron-optical projection device is configured to scan the at least one charged particle beam over a scan area of the sample location, and wherein the optical member comprises at least one out-coupling feature configured for directing stimulation light towards the sample to at least partially overlap the scan area.

8. The device according to claim 7, wherein the coating layer is disposed to cover the at least one out-coupling feature.

9. The device of claim 7 or claim 8, wherein the at least one out-coupling feature comprises a reflective element and/or comprises a diffraction grating.

10. The device according to any of claims 7 to 9, wherein the coating layer comprises a first layer and a second layer, wherein:
the first layer is disposed as a pattern on the first surface of the optical member, the first layer being disposed so that it does not obstruct the at least one out-coupling feature; and
the second layer is disposed in gaps formed by the pattern of the first layer to cover the at least one out-coupling feature.

11. The device according to any of claims 7 to 9, wherein the coating layer comprises a first layer and a second layer, wherein:
the first layer being disposed as a pattern on the first surface of the optical member, the first layer being disposed so that it does not obstruct the at least one out-coupling feature; and
the second layer is disposed to cover the first layer and the at least one out-coupling feature.

12. The device according to any of claims 7 to 9, wherein the coating layer comprises a first layer and a second layer, the first layer being disposed as a pattern on top of a continuous second layer and the first layer being disposed so that it does not obstruct the at least one outcoupling feature.

13. The device according to any one of claims 9 to 12, wherein the first layer has a higher conductance than the second layer, and/or wherein the first layer has a lower transmittance than the second layer.

14. The device according to any one of claims 9 to 13, wherein the pattern comprises a mesh.

15. The device according to any of the preceding claims, wherein the electron-optical projection device is configured for projecting a plurality of charged particle beams towards the sample, and wherein the optical member is configured to direct stimulation light towards the sample so that the stimulation light is at least partially coincident with the plurality of charged particle beams.
